# EUROPEAN PATENT APPLICATION

(11) **EP 4 642 178 A1**
(43) Date of publication of application: **29.10.2025**
(21) Application number: 25163417.6
(22) Date of filing: 13.03.2025
(51) Int. Cl.: H05K 7/20

(54) **HYBRID AIR/LIQUID COOLING SYSTEM WITH INTERNAL TEMPERATURE CONTROL**

(30) Priority: 21.03.2024 US 202463568297 P; 11.02.2025 US 202563757025 P; 06.03.2025 US 202519072759
(71) Applicant: Vertiv Corporation, Westerville, OH 43082 (US)
(72) Inventor: Blaser, Colin L., Westerville, 43082 (US); Breuer, Thomas C., Westerville, 43082 (US); Raven, Matthew A., Westerville, 43082 (US); Miller, Oliver M., Westerville, 43082 (US); Nebraska, Jack T., Westerville, 43082 (US); King, Jeremy R., Westerville, 43082 (US)
(74) Representative: Cousens, Nico

(57) **Abstract**

A hybrid cooling system includes a refrigerant circuit having at least one first heat exchanger and a liquid cooling circuit having at least one second heat exchanger. A controller operates a valve assembly to selectively flow refrigerant to one or more of the refrigerant and liquid cooling circuits depending on the operating mode of the hybrid cooling system. In embodiments, when the liquid cooling circuit is operative, the controller is configured to implement a control methodology whereby one or more fans associated with the air cooling circuit are powered on to cool at least a portion of the hybrid cooling system, for instance lower an internal temperature in a confined when the hybrid cooling system is implemented as a self-contained unit.

## Description

### CROSS REFERENCE TO RELATED APPLICATIONS

This nonprovisional application claims the benefit under 35 U.S.C. § 119(e) of U.S. Provisional Application No. 63/568,297 filed March 21, 2024 for HYBRID AIR/LIQUID COOLING UNIT, and U.S. Provisional Application No. 63/757,025 filed February 11, 2025 for HYBRID AIR/LIQUID COOLING SYSTEM WITH INTERNAL TEMPERATURE CONTROL.

### TECHNICAL FIELD

The present disclosure relates generally to cooling systems for electronic equipment, and more particularly, to a hybrid air/liquid cooling system with internal fan control for managing internal unit temperature.

### BACKGROUND

Data centers and other computing environments house high performance electronic equipment that must be thermally protected. Thermal protection is typically achieved using a cooling system that includes one or more cooling circuits that operate to transfer heat from one location to another. For example, in a data center, a cooling circuit can be used to cool electronic equipment by transferring heat away from electronic equipment, from one space to another, from inside a building to outside a building, etc.

Traditional cooling systems typically utilize a single cooling medium (e.g., air or liquid). Recent advancements in cooling systems may include two types of cooling mediums within the same system, referred to as a hybrid cooling system. In such systems, an air cooling circuit typically includes a first heat exchanger configured to transfer heat from the ambient air to a refrigerant, and a liquid cooling circuit typically includes a second heat exchanger configured to transfer heat from a liquid to the refrigerant. In use, the air and liquid cooling circuits may operate contemporaneously or mutually exclusive such that when one cooling circuit is operative the other is inoperative.

Traditional liquid cooling circuits include one or more pumps housed within a unit configured to circulate liquid to a cooling distribution unit (CDU) or directly to the electronic equipment. While efficient, a portion (e.g., approximately 10%) of the pump energy is transferred to the air within the unit in the form of heat. As the liquid circuit operates over time, heat may build up in the unit which poses a risk to the mechanical and electronic equipment within the unit. As such, it may be necessary to exhaust the air within the unit from time to time to reduce the unit air temperature.

While dedicated exhaust fans are known for exhausting air from within a confined space (e.g., cabinet), they increase the cost and complexity of a unit, require dedicated venting, and constrain the location of other equipment within the unit. Therefore, what is needed is a provision for managing air temperature within a hybrid air/liquid cooling system without the need for dedicated exhaust fans.

### SUMMARY

According to one aspect, disclosed herein is a cooling system including a refrigerant circuit, an air cooling circuit in fluid communication with the refrigerant circuit, the air cooling circuit including at least one first heat exchanger and at least one fan configured to flow air over the at least one first exchanger, a liquid cooling circuit in fluid communication with the refrigerant circuit, the liquid cooling circuit including at least one second heat exchanger and at least one pump, a valve assembly configured to selectively flow refrigerant to at least one of the air cooling circuit and the liquid cooling circuit, and a controller communicatively coupled to the valve assembly and the at least one fan. In embodiments, the controller includes one or more processors configured to operate the cooling system in a first operating mode in which the air cooling circuit is operative and the liquid cooling circuit is inoperative, and operate the cooling system in a second operating mode in which the air cooling circuit is inoperative, the liquid cooling circuit is operative, and the at least one fan is selectively operative to cool at least a portion of the cooling system.

According to another aspect, disclosed herein is a hybrid air/liquid cooling unit including a cabinet defining an interior space, a refrigerant circuit contained in the interior space, an air cooling circuit contained in the interior space and in fluid communication with the refrigerant circuit, the air cooling circuit including at least one first heat exchanger and at least one fan configured to flow air over the at least one first exchanger, a liquid cooling circuit contained in the interior space and in fluid communication with the refrigerant circuit, the liquid cooling circuit including at least one second heat exchanger and at least one pump, a valve assembly contained in the interior space and configured to selectively flowing refrigerant to at least one of the air cooling circuit and the liquid cooling circuit, and a controller communicatively coupled to the valve assembly and the at least one fan, the controller including one or more processors. In embodiments, the controller is configured to operate the hybrid air/liquid cooling unit in a first operating mode in which the air cooling circuit is operative and the liquid cooling circuit is inoperative, and operate the hybrid air/liquid cooling unit in a second operating mode in which the air cooling circuit is inoperative, the liquid cooling circuit is operative, and the at least one fan is selectively operative to exhaust air from the interior space.

According to a further aspect, disclosed herein is a method for controlling a hybrid air/liquid cooling unit including providing a cabinet defining an interior space, a refrigerant circuit contained in the interior space, an air cooling circuit contained in the interior space and in fluid communication with the refrigerant circuit, the air cooling circuit including at least one first heat exchanger and at least one fan configured to flow air over the at least one first exchanger, a liquid cooling circuit contained in the interior space and in fluid communication with the refrigerant circuit, the liquid cooling circuit including at least one second heat exchanger and at least one pump, and a valve assembly contained in the interior space and configured to selectively flowing refrigerant to at least one of the air cooling circuit and the liquid cooling circuit. The method further includes providing a controller communicatively coupled to the valve assembly and the at least one fan, the controller including one or more processors. In embodiments, the method includes operating, by the controller, the hybrid air/liquid cooling unit in a first operating mode in which the air cooling circuit is operative and the liquid cooling circuit is inoperative, and operating, by the controller, the hybrid air/liquid cooling unit in a second operating mode in which the air cooling circuit is inoperative, the liquid cooling circuit is operative, and the at least one fan is selectively operative to exhaust air from the interior space.

This summary is provided solely as an introduction to subject matter that is fully described in the following detailed description and drawing figures. This summary should not be considered to describe essential features nor be used to determine the scope of the claims. Moreover, it is to be understood that both the foregoing summary and the following detailed description are explanatory only and are not necessarily restrictive of the subject matter claimed.

### BRIEF DESCRIPTION OF THE DRAWINGS

Implementations of the present disclosure disclosed herein may be better understood when consideration is given to the following detailed description thereof. Such description refers to the included drawings, which are not necessarily to scale, and in which some features may be exaggerated and some features may be omitted or may be represented schematically in the interest of clarity. Like reference numerals in the drawings may represent and refer to the same or similar element, feature, or function. In the drawings:
FIG. 1 is a schematic diagram of a hybrid cooling system, in accordance with an example embodiment of the present disclosure;
FIG. 2 is a schematic diagram of the hybrid cooling system further including a controller, in accordance with an example embodiment of the present disclosure;
FIG. 3 is a schematic diagram of a hybrid cooling system including a new and legacy cooling circuit integration, in accordance with an example embodiment of the present disclosure;
FIG. 4 is a schematic diagram of the hybrid cooling system further including a cooling distribution unit, in accordance with an example embodiment of the present disclosure;
FIG. 5 is a schematic diagram of the hybrid cooling system shown operating in a first operating state corresponding to air cooling, in accordance with an example embodiment of the present disclosure;
FIG. 6 is a schematic diagram of the hybrid cooling system shown operating in a second operating state corresponding to liquid cooling, in accordance with an example embodiment of the present disclosure;
FIG. 7 is a schematic diagram of the hybrid cooling system shown operating in a third operating state corresponding to air and liquid cooling, in accordance with an example embodiment of the present disclosure;
FIG. 8 is a schematic diagram of a cooling system including a plurality of cooling circuits, in accordance with an example embodiment of the present disclosure;
FIG. 9 is a schematic diagram of a cooling system implemented as a hybrid air-liquid cooling unit, in accordance with an example embodiment of the present disclosure;
FIG. 10 is a schematic diagram of the hybrid air/liquid cooling unit illustrating air flow through the unit, in accordance with an example embodiment of the present disclosure; and
FIG. 11 is a flow diagram illustrating a method for managing internal temperature in a hybrid air/liquid cooling unit, in accordance with an example embodiment of the present disclosure.

### DETAILED DESCRIPTION

Before explaining one or more embodiments of the disclosure in detail, it is to be understood that the embodiments are not limited in their application to the details of construction and the arrangement of the components or steps or methodologies set forth in the following description or illustrated in the drawings. In the following detailed description of embodiments, numerous specific details may be set forth in order to provide a more thorough understanding of the disclosure. However, it will be apparent to one of ordinary skill in the art having the benefit of the instant disclosure that the embodiments disclosed herein may be practiced without some of these specific details. In other instances, well-known features may not be described in detail to avoid unnecessarily complicating the instant disclosure.

As used herein a letter following a reference numeral is intended to reference an embodiment of the feature or element that may be similar, but not necessarily identical, to a previously described element or feature bearing the same reference numeral (e.g., 1, 1a, 1b). Such shorthand notations are used for purposes of convenience only and should not be construed to limit the disclosure in any way unless expressly stated to the contrary.

Further, unless expressly stated to the contrary, "or" refers to an inclusive or and not to an exclusive or. For example, a condition A or B is satisfied by any one of the following: A is true (or present), and B is false (or not present), A is false (or not present) and B is true (or present), and both A and B are true (or present).

In addition, the use of "a" or "an" may be employed to describe elements and components of embodiments disclosed herein. This is done merely for convenience and "a" and "an" are intended to include "one" or "at least one," and the singular also includes the plural unless it is obvious that it is meant otherwise.

Finally, as used herein any reference to "one embodiment" or "embodiments" means that a particular element, feature, structure, or characteristic described in connection with the embodiment is included in at least one embodiment disclosed herein. The appearances of the phrase "in embodiments" in various places in the specification are not necessarily all referring to the same embodiment, and embodiments may include one or more of the features expressly described or inherently present herein, or any combination or sub-combination of two or more such features, along with any other features which may not necessarily be expressly described or inherently present in the instant disclosure.

Disclosed herein is a hybrid air/liquid cooling system implemented as a unit housing cooling circuits, and a method for managing air temperature within the unit using internal fan control. In embodiments, the hybrid air/liquid cooling unit includes a first heat exchanger (e.g., evaporator coil) associated with an air cooling circuit, and a second heat exchanger (e.g., braze plate heat exchanger (BPHE)) associated with a liquid cooling circuit. The hybrid air/liquid cooling unit may operate to provide cooling that is 100% air cooled, 100% liquid cooled, or a mixture of air cooling and liquid cooling. When operating the liquid cooling circuit to provide liquid cooling, the internal fan/blower associated with the air cooling circuit may be cycled on an off to exhaust hot air from within the unit as needed, thereby maintaining an internal air temperature and obviating the need for a dedicated cabinet exhaust fan and corresponding venting.

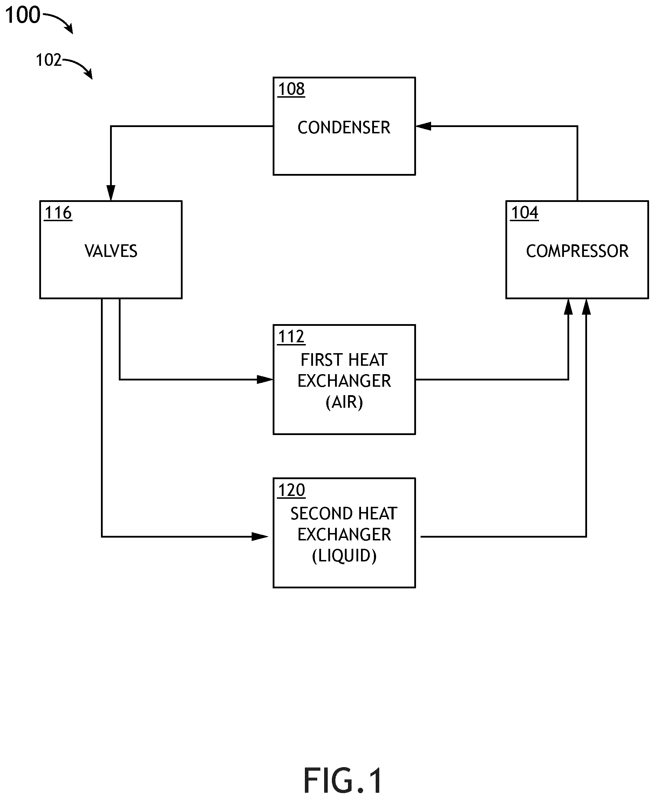

FIG. 1 is a system diagram illustrating a cooling system 100 for hybrid cooling of electronic equipment. In embodiments, the cooling system 100 includes a cooling circuit 102 configured to circulate a refrigerant. Suitable refrigerants may include, but are not limited to, R22, R410A, R407C, R744, R134a, R1234yf, R290, R600a, R718, and R454B. The cooling circuit 102 includes at least one compressor 104 configured to pressurize the refrigerant, and at least one condenser 108 configured to reject heat from the refrigerant. The cooling circuit 102 further includes a first heat exchanger 112 associated with an air cooling circuit, and a second heat exchanger 120 associated with a liquid cooling circuit. In embodiments, the first heat exchanger 112 may be an evaporator configured to absorb heat in the refrigerant, and the second heat exchanger 120 may be a brazed plate heat exchanger (BPHE) configured to transfer heat from a secondary liquid (e.g., water or propylene glycol) to the refrigerant. Within the cooling circuit 102, the first heat exchanger 112 and the second heat exchanger 120 may utilize the same refrigerant (e.g., a portion of the refrigerant that flows through the first heat exchanger 112 may also flow through the second heat exchanger 120 and vice versa).

In embodiments, the cooling system 100 further includes one or more valves 116 (e.g., expansion valves) configured to control the flow of the refrigerant selectively through the first heat exchanger 112 and the second heat exchanger 120 to the one or more compressors 104. In embodiments, the one or more valves 116 may control the percentage of refrigerant flowing as a liquid or as a gas/vapor to ensure that the refrigerant is in gas/vapor form before returning to the compressors 104.

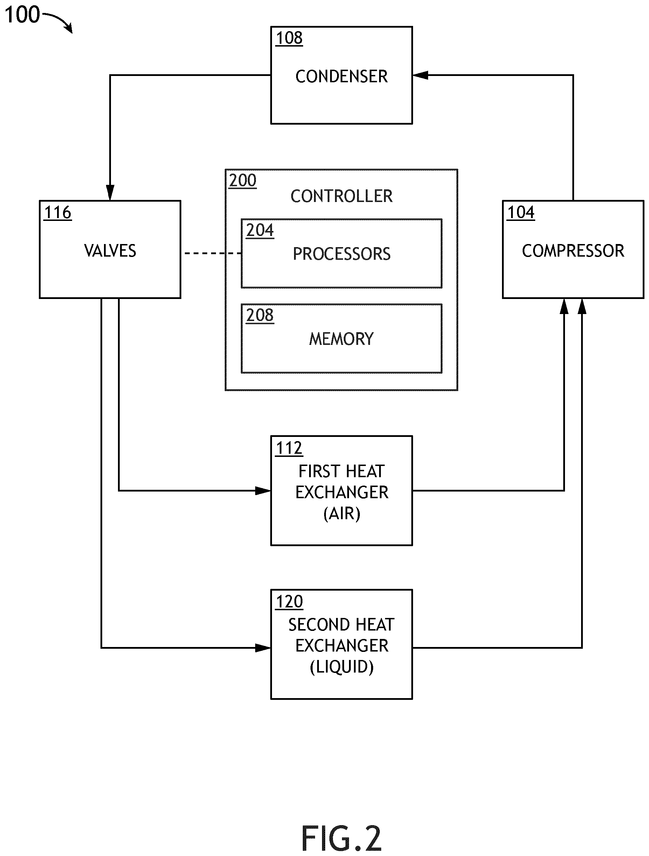

FIG. 2 is a system diagram illustrating the cooling system 100 further including a controller 200 configured to control the operating mode of the cooling system 100. For example, the controller 200 may control the action of the one or more valves 116 of the system to control the flow of refrigerant such that the system may operate in a first operating mode in which the air cooling circuit is operative and the liquid cooling circuit is inoperative, a second operating mode in which the liquid cooling circuit is operative and the air cooling circuit is operative, and a third operating mode in which at least a portion of the air and liquid cooling circuits are operative. In embodiments, the controller 200 may control other aspects or components of the cooling system 100 such as the one or more compressors 104 and the one or more fans/blowers operating within the cooling system 100 as discussed in detail below, among other system components.

In embodiments, the controller 200 includes one or more processors 204 and memory 208 that facilitate the controller 200 in controlling one or more functions of the cooling system 100. In embodiments, the one or more processors 204 are configured to receive instructions (e.g., from memory 208 or from an input from an operator via a user interface) to open or close one or more valves 116 and operate the one or more fans/blowers, as described herein. In embodiments, the one or more processors 204 are configured to transmit a signal to the one or more valves 116 and the one or more fans/blowers based on the instructions, as described herein.

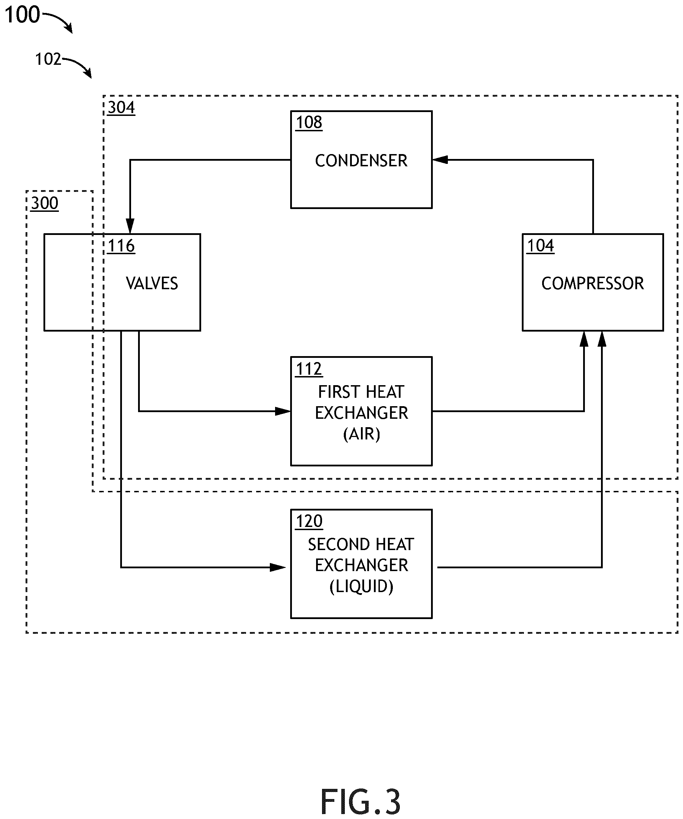

FIG. 3 is a system diagram illustrating an integration of a liquid cooling circuit 300 with a legacy air cooling circuit 304, and the disposition of the one or more valves 116 for selectively flowing the refrigerant through at least one of the liquid and air cooling circuits 300, 304.

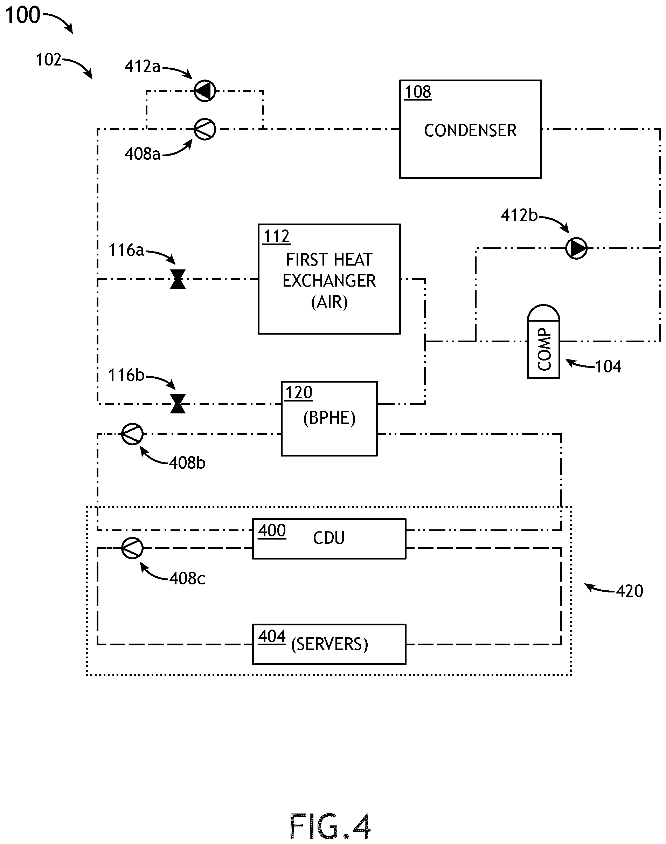

FIG. 4 is a system diagram illustrating the cooling system 100 further including a cooling distribution unit (CDU) 400. In use, the CDU 400 receives chilled secondary fluid from the second heat exchanger 120 and circulates the chilled secondary fluid, or a chilled tertiary fluid (e.g., water or propylene glycol) that has exchanged heat with the secondary fluid via the CDU 400, to the electronic equipment 404 (e.g., servers). Heat from the electronic equipment 404 heats the secondary fluid or tertiary fluid, and heat from these fluids is transferred back to the second heat exchanger 120 via circulation. In embodiments, the secondary fluid may also be circulated directly between the second heat exchanger 120 and the electronic equipment 404 without the CDU 400.

In embodiments, the cooling system 100 includes a first valve 116a configured to control the flow of refrigerant to the first heat exchanger 112, and a second valve 116b configured to control the flow of refrigerant to the second heat exchanger 120. In embodiments, the cooling system 100 further includes one or more pumps 408a-c. For example, the cooling system 100 may include a first pump 408a configured to circulate refrigerant, and one or more second pumps 408b, 408c configured to circulate secondary fluid through the second heat exchanger 120, the electronic equipment 404 (e.g., to computer chips within the servers) and/or the CDU 400. The cooling system 100 may further include one or more check valves 412a, 412b configured to prevent backflow of refrigerant. The pumps 408a-c and check valves 112a, 112b may be part of a complementary heating system that adds efficiency to the system 100. For example, the pumps and check valves may facilitate the circulation of refrigerant without the use of the one or more compressors 104. For instance, in times where the temperature outside is colder than the saturation temperature of the refrigerant, the system 100 may rely on the pumps and check valves to circulate refrigerant in the absence of the compressor, thereby reducing the power expended to circulate refrigerant.

In embodiments, a portion of the cooling system 100 may be physically located within a server environment 420 (e.g., the location of the servers or other electronic equipment 404 (data centers)). For example, the CDU 400 and the electronic equipment 404 being cooled may be located within the server environment 420. In another example, the CDU 400, the electronic equipment 404, and the second heat exchanger 120 may be located within the server environment. In another example, the electronic equipment 404 is within the server environment 420.

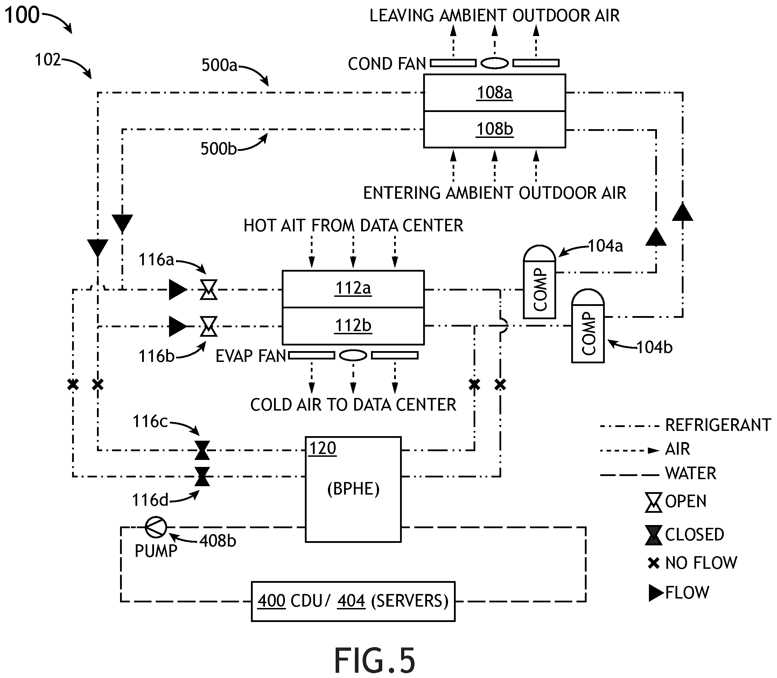

FIGS. 5-7 illustrate a more detailed schematic view of the cooling system 100 operating under different conditions. FIGS. 5-7 illustrate the cooling system 100 with one or more compressors 104a, 104b, one or more condensers 108a, 108b (e.g., multiple condenser coils), one or more first heat exchangers 112a, 112b (e.g., multiple evaporator coils), and multiple valves 116a-d (e.g., first heat exchanger valves 116a-b and second heat exchanger valves 116c-d). The cooling system 100 may include any number of compressors 104, condensers 108, first heat exchangers 112a, 112b, and second heat exchanger 120. The cooling system 100 may include multiple primary refrigerant circulation loops 500a, 500b. The system may further include one or more secondary cooling loops 502. For example, the one or more cooling circuits 102 of the cooling system 100 may include, or be in fluid communication with, two secondary cooling loops 502.

FIG. 5 illustrates the cooling system 100 operating in the first operating mode in which the cooling is performed via the air cooling circuit and the first heat exchangers 112a, 112b. In this configuration, the first heat exchanger valves 116a, 116b are open (e.g., as indicated by the white valve icon), while the second heat exchanger valves 116c, 116d are closed (e.g., as indicated by the black valve icon), thereby allowing refrigerant to circulate through the one or more first heat exchangers 112a, 112b, and preventing refrigerant from circulating through the second heat exchanger 120. Areas of circulation are denoted with an arrow in FIGS. 5-7, while areas of no flow are denoted by an "x".

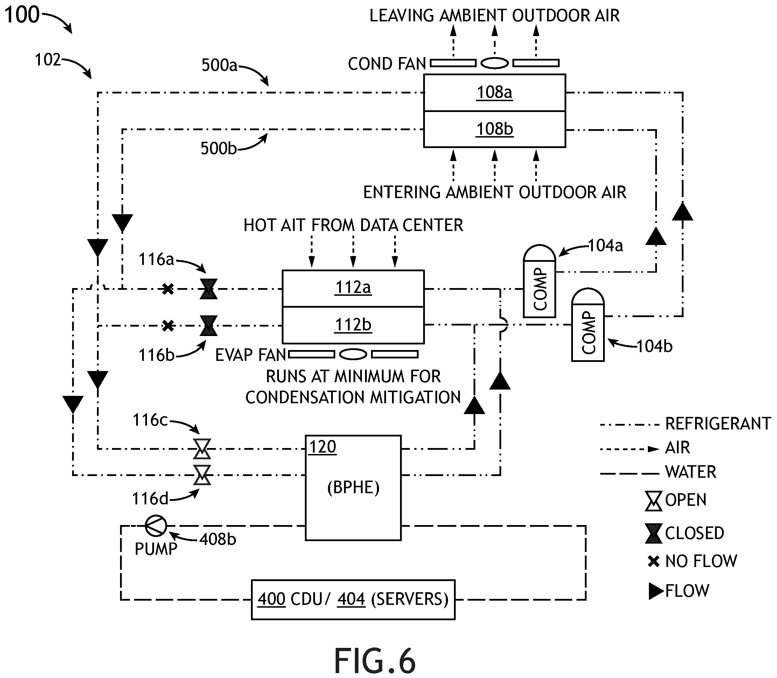

FIG. 6 illustrates the cooling system 100 operating in the second operating mode in which the cooling is liquid cooling performed by the second heat exchanger 120. In this operating mode, the first heat exchanger valves 116a, 116b are closed while the second heat exchanger valves 116c, 116d are open, thereby allowing refrigerant to circulate through the second heat exchanger 120 and preventing refrigerant from circulating through the one or more first heat exchangers 112a, 112b. Areas of circulation are again denoted with an arrow, while areas of no flow are denoted by an "x".

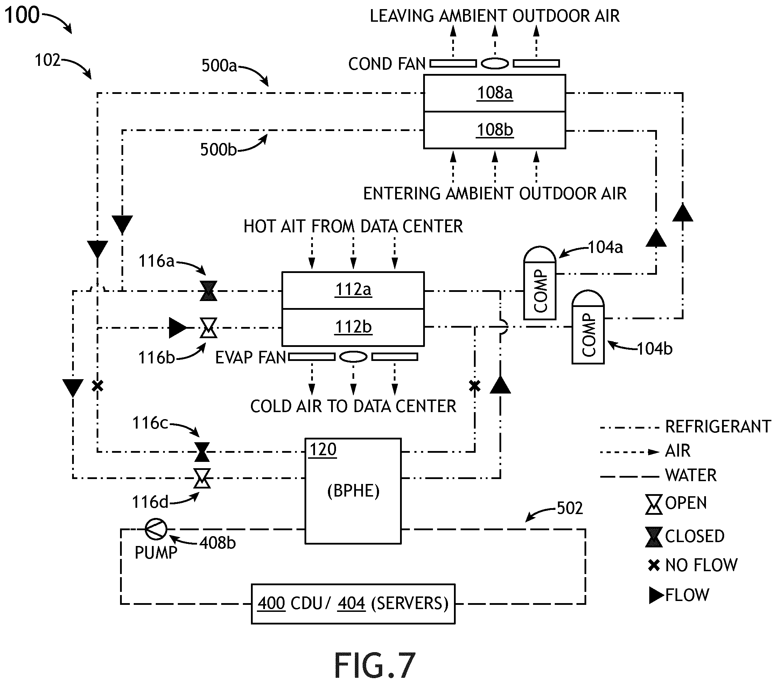

FIG. 7 illustrates the cooling system 100 operating in a third operating mode in which cooling is performed by both (e.g., in any predefined ratio) the air cooling circuit via the one or more first heat exchangers 112a, 112b and the liquid cooling circuit via the second heat exchanger 120. In this configuration, one of the first heat exchanger valves 116a is closed with the other first heat exchanger valve 116b opened, while one of the second heat exchanger valves 116c is closed with the other second heat exchanger valve 116d opened, thereby allowing refrigerant to be cooled by both the air and liquid mediums. The cooling system 100 may be configured to control the proportion of cooling by each of the air and liquid cooling circuits by controlling the flow of refrigerant to the one or more first heat exchanger 112 and the second heat exchanger 120.

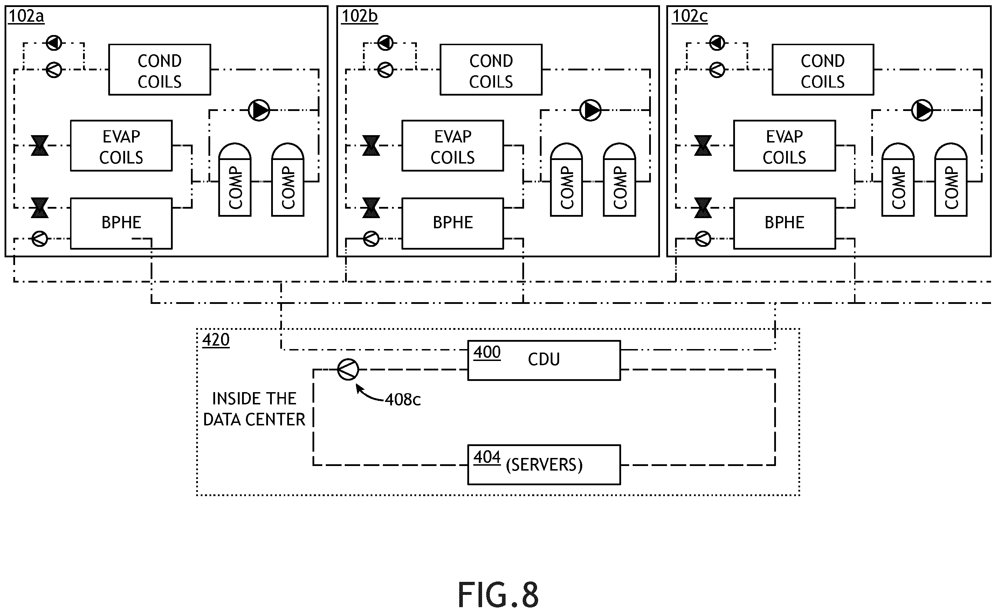

FIG. 8 is a system diagram illustrating a plurality of cooling circuits 102a-c. The cooling system 100 may include any number of cooling circuits 102a-c including, but not limited to, a single cooling circuit 102a, two cooling circuits 102a, 102b, three cooling circuits 102a-c, ten cooling circuits, thirty cooling circuits, n cooling circuits 102, etc., depending on the application. For example, the cooling system 100 may include up to thirty-two cooling circuits. The cooling circuits 102a-c may be in fluid communication with any number of CDUs 400 or electronic equipment 404 (e.g., servers) and may be organized in parallel with a set of CDUs 400 or electronic equipment 404.

In embodiments, one or more processors 204 are configured to receive instructions regarding the operating mode of the system 100. For example, the instructions may include controlling the open or closed state of the valves 116 (e.g., ON and OFF instructions) of the one or more cooling circuits 102. The one or more processors 204 may also be configured to transmit a signal to the valves 116 based on the instructions for each of the cooling circuits. For example, for a cooling system 100 including ten cooling circuits 102, the cooling system 100 may be instructed to, and be executed by the one or more processors 204 of the controller 200 to, operate the valves 116 such that some of the cooling circuits 102 operate in the first operating mode for air cooling and some of the cooling circuits 102 operate in the second operating mode for liquid cooling. Thus, within the cooling system, each of the cooling circuits 102 is independently controllable.

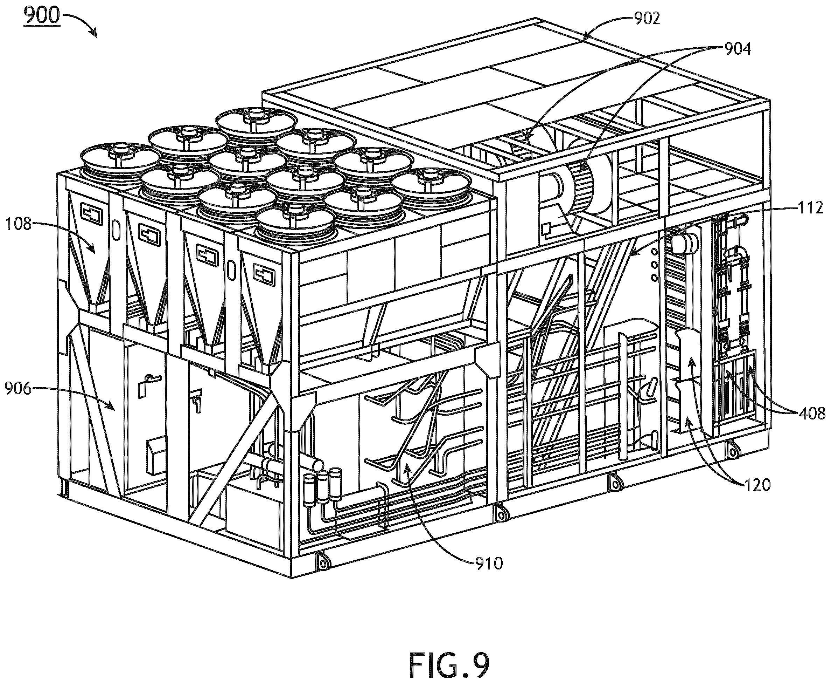

FIG. 9 is a schematic illustration of the cooling system implemented as a hybrid air/liquid unit 900. In embodiments, the hybrid air/liquid unit 900 may be self-contained and positioned in relation to electronic equipment housed in a data center. In embodiments, the hybrid air/liquid unit 900 may include one or more cabinets 902 defining one or more interior spaces for containing cooling system components. The interior spaces and system component dispositions as shown may vary. For example, the hybrid air/liquid unit 900 may contain the condensers 108, an electrical cabinet 906, a compressor compartment 910, the one or more first heat exchangers 112 associated with the air cooling circuit, the one or more second heat exchangers 120 associated with the liquid cooling circuit, and the pumps 408 associated with the liquid cooling circuit. In embodiments, the one or more of the interior spaces may be confined spaces. In embodiments, one or more fans 904 (e.g., blowers) are disposed within the unit and are associated with the air cooling circuit. In use, the one or more fans 904 operate to draw air into the unit 900 and flow air over the one or more first exchangers 112, as discussed below.

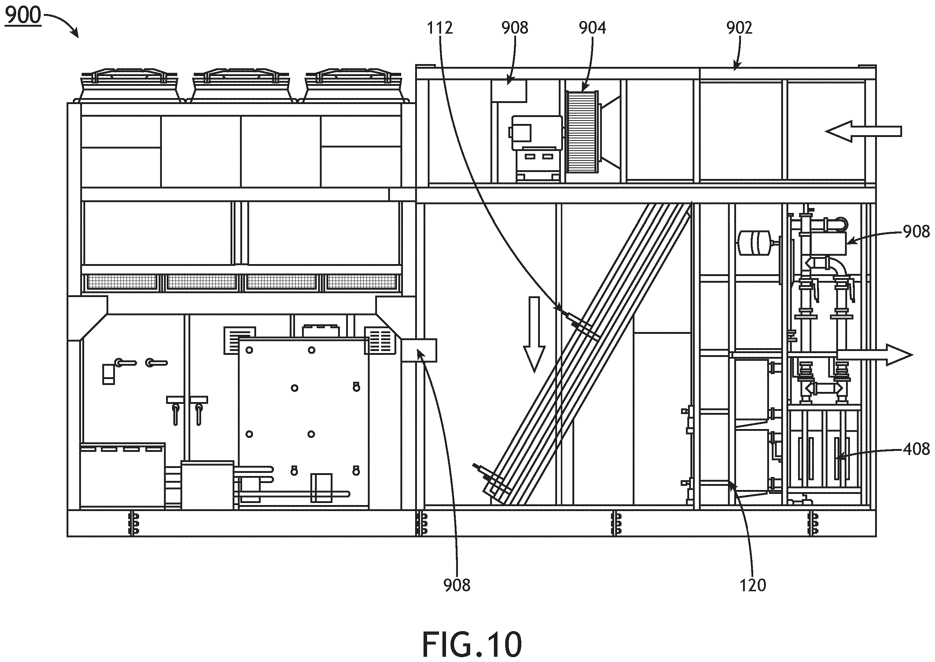

FIG. 10 illustrates air flow through the hybrid air/liquid unit 900 via the action of the one or more fans 904. In embodiments, 'hot' air from the environment is drawn in through a first (e.g., upper) portion of the unit when the one or more fans 904 are powered on. The 'hot' air, drawn into the unit by the one or more fans 904, is directed to flow over the one or more first heat exchangers 112 associated with the air cooling circuit whereby heat is absorbed by the refrigerant and the produced cold air is directed out through a second (e.g. lower) portion of the unit directed toward the electronic equipment to be cooled. When the cooling system 100 is operating in the first operating mode corresponding to air cooling, the one or more fans are powered on and may run continuously to direct air through the unit 900 as shown.

In a traditional hybrid system operating in a liquid cooling mode, the one or more fans 904 associated with the air cooling circuit would typically be powered off. According to the present disclosure, when operating the cooling system 100 in the second operating mode corresponding to liquid cooling, the one or more fans 904 associated with the air cooling circuit may be cycled 'on' and 'off' as needed to exhaust 'hot' air from within the unit 900, for instance from within a confined space within the unit 900. More specifically, when operating in the second operating mode in which the air cooling circuit is inoperative, liquid cooling is achieved by the second heat exchanger 120 associated with the liquid cooling circuit. When the liquid cooling circuit is operative, the one or more pumps 408 associated with the liquid cooling circuit are powered on to circulate the liquid medium to the electronic equipment and/or the CDU 400. When the pumps 408 are powered on, the electric motors associated with the pumps produce heat. The heat produced by the operating electric motors, because of the disposition of the pumps 408 and motors within the unit 900, and in some cases within a confined space, may cause the air temperature within the unit 900 to rise. Over time as the liquid cooling circuit is operative, heat may build up within the unit 900 to a temperature that may cause damage to the system components, for instance the electrical components housed within the unit 900. In that case, it may be necessary to exhaust the hot air from inside the unit 900 to maintain an acceptable air temperature within the unit 900.

In embodiments, the unit 900 may include one or more temperature sensors 908 configured to sense the internal air temperature within the unit 900. The one or more temperature sensors 908 may be positioned within the unit 900 in predetermined areas, for instance proximal to the pumps 408, the one or more first heat exchangers 112, the one or more fans 904, electronic components, etc. In use, the one or more temperature sensors 908 are configured to output temperature data to the controller 200, whereby the temperature data is received by the controller 200, processed, and utilized to cycle 'on' and 'off' the one or more fans 904 as needed to exhaust the 'hot' air within the unit 900.

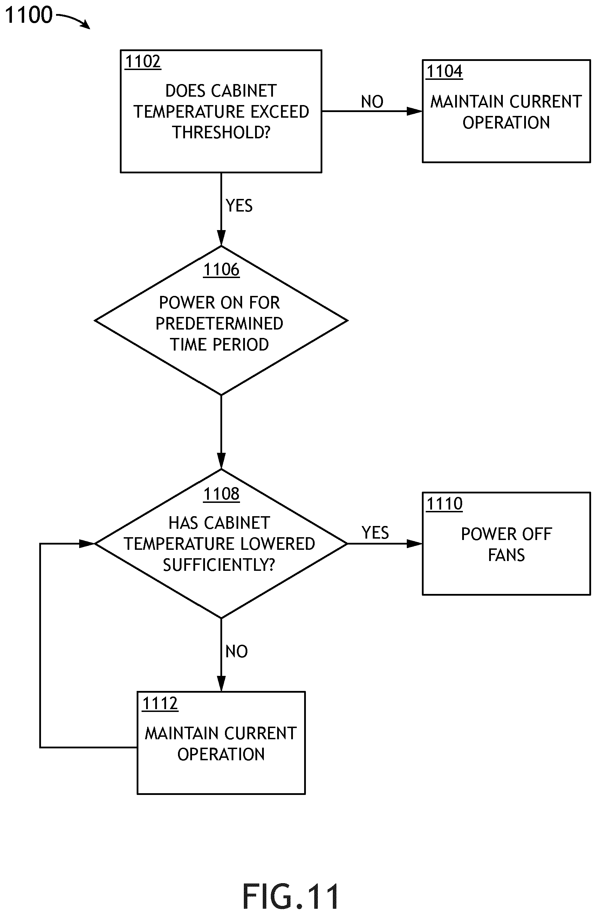

FIG. 11 illustrates a temperature control scheme/methodology 1100 for managing unit temperature. In step 1102, the controller 200 is configured to determine, from data received from the one or more temperature sensors 908, if the internal air temperature in the unit exceeds a predefined threshold air temperature while the cooling system 100 is operating in the second operating mode corresponding to liquid cooling. In step 1104, if the internal air temperature is determined to be below the predefined threshold temperature, the second operating mode is maintained without powering one the one or more fans 904 associated with the air cooling circuit. In step 1106, if the internal air temperature is determined to exceed the threshold temperature, the one or more fans 904 are powered on for a predetermined time period to exhaust the air within the unit 900.

In embodiments, the one or more fans 904 within the unit may be the type having sensitive contacts susceptible to damage from repeated cycling 'on' and 'off' and short duration operation. As such, the time period in which the one or more fans 904 are powered on may be several continuous minutes to ensure the 'hot' air within the unit has been exhausted and the air temperature returned to a safe operating temperature (e.g., below the threshold temperature). For example, the predefined time period may be 5 minutes, 10 minutes, 15 minutes, etc. In embodiments, in the case of variable speed one or more fans 904, the one or more fans 904 may be run at low or minimum speed during the second operating mode corresponding to liquid cooling such that a minimal volume of hot air is directed toward the electronic equipment to be cooled by the liquid cooling circuit. In other words, considering the hot air may be exhausted through the outlet corresponding to the air cooling circuit, it is desired to minimize the air flow volume during the unit cooling operating mode.

Continuing with the method 1100, in step 1108, the controller 200 determines from the one or more sensors 908 if the air temperature within the unit 900 has decreased below the predefined threshold temperature, and in some embodiments to a predefined amount below the predefined threshold temperature. In step 1108, the temperature determination may be made while the one or more fans 904 are running, for instance near in time to the end of the predefined time period (e.g., minute 8 or 9 in the case of a 10 minute time period). In step 1110, if it is determined that the air temperature in the unit 900 has decreased to below the predefined temperature threshold, the one or more fans 904 may be powered 'off' at the end of the predefined time period. In step 1112, if it is determined that the air temperature in the unit 900 has not sufficiently decreased to below the predefined threshold temperature, then the one or more fans 904 may continue to run consecutively for another predefined time period to avoid having to power 'off' and then power 'on' the one or more fans 904 twice or more.

In embodiments, the one or more processors 204 of the controller 200 may be implemented as any suitable processor(s), such as at least one general purpose processor, at least one central processing unit (CPU), at least one image processor, at least one graphics processing unit (GPU), at least one field-programmable gate array (FPGA), and/or at least one special purpose processor configured to execute instructions for performing (e.g., collectively performing if more than one processor) any or all of the operations disclosed throughout.

Also disclosed herein are the following numbered clauses:
1. A hybrid air/liquid cooling unit comprising:
   a cabinet defining an interior space;
   a refrigerant circuit contained in the interior space;
   an air cooling circuit contained in the interior space and in fluid communication with the refrigerant circuit, the air cooling circuit including at least one first heat exchanger and at least one fan configured to flow air over the at least one first exchanger;
   a liquid cooling circuit contained in the interior space and in fluid communication with the refrigerant circuit, the liquid cooling circuit including at least one second heat exchanger and at least one pump;
   a valve assembly contained in the interior space and configured to selectively flowing refrigerant to at least one of the air cooling circuit and the liquid cooling circuit; and
   a controller communicatively coupled to the valve assembly and the at least one fan, the controller including one or more processors configured to:
      operate the hybrid air/liquid cooling unit in a first operating mode in which the air cooling circuit is operative and the liquid cooling circuit is inoperative; and
      operate the hybrid air/liquid cooling unit in a second operating mode in which the air cooling circuit is inoperative, the liquid cooling circuit is operative, and the at least one fan is selectively operative to exhaust air from the interior space.
2. The hybrid air/liquid cooling unit of clause 1, further comprising:
   at least one temperature sensor disposed in the interior space, the at least one temperature sensor configured to sense an internal air temperature in the interior space;
   wherein the controller is communicatively coupled to the at least one temperature sensor, and is further configured to:
      when the hybrid air/liquid cooling unit is operating in the second operating mode, power on the at least one fan when the internal air temperature in the interior space exceeds a predefined threshold air temperature.
3. The hybrid air/liquid cooling unit of clause 2, wherein the at least one fan is powered on for a predefined time period.
4. The hybrid air/liquid cooling unit of clause 3, wherein the controller is further configured to:
   when the at least one fan is powered on for the predefined time period, determine from the at least one temperature sensor if the internal air temperature in the interior space has decreased to below the predefined threshold air temperature; and
   if the internal air temperature in the interior space is determined to have decreased to below the predefined threshold air temperature, power off the at least one fan; and
   if the internal air temperature in the interior space is determined not to have decreased below the predefined threshold air temperature, maintain the at least one fan powered on for another consecutive predefined time period.
5. The hybrid air/liquid cooling unit of any preceding clause, wherein the at least one first heat exchanger comprises an evaporator coil.
6. The hybrid air/liquid cooling unit of any preceding clause, wherein the at least one second heat exchanger comprises a braze plate heat exchanger (BPHE).
7. The hybrid air/liquid cooling unit of any preceding clause, wherein the cabinet does not include a dedicated exhaust fan.

Those having skill in the art will recognize that the state of the art has progressed to the point where there is little distinction left between hardware and software implementations of aspects of systems; the use of hardware or software is generally (but not always, in that in certain contexts the choice between hardware and software can become significant) a design choice representing cost vs. efficiency tradeoffs. Those having skill in the art will appreciate that there are various vehicles by which processes and/or systems and/or other technologies described herein can be implemented (e.g., hardware, software, and/or firmware), and that the preferred vehicle will vary with the context in which the processes and/or systems and/or other technologies are deployed. For example, if an implementer determines that speed and accuracy are paramount, the implementer may opt for a mainly hardware and/or firmware vehicle; alternatively, if flexibility is paramount, the implementer may opt for a mainly software implementation; or, yet again alternatively, the implementer may opt for some combination of hardware, software, and/or firmware. Hence, there are several possible vehicles by which the processes and/or devices and/or other technologies described herein may be implemented, none of which is inherently superior to the other in that any vehicle to be utilized is a choice dependent upon the context in which the vehicle will be deployed and the specific concerns (e.g., speed, flexibility, or predictability) of the implementer, any of which may vary.

The foregoing detailed description has set forth various embodiments of the devices and/or processes via the use of block diagrams, flowcharts, and/or examples. Insofar as such block diagrams, flowcharts, and/or examples contain one or more functions and/or operations, it will be understood by those within the art that each function and/or operation within such block diagrams, flowcharts, or examples can be implemented, individually and/or collectively, by a wide range of hardware, software, firmware, or virtually any combination thereof. In one embodiment, several portions of the subject matter described herein may be implemented via Application Specific Integrated Circuits (ASICs), Field Programmable Gate Arrays (FPGAs), digital signal processors (DSPs), or other integrated formats. However, those skilled in the art will recognize that some aspects of the embodiments disclosed herein, in whole or in part, can be equivalently implemented in integrated circuits, as one or more computer programs running on one or more computers (e.g., as one or more programs running on one or more computer systems), as one or more programs running on one or more processors (e.g., as one or more programs running on one or more microprocessors), as firmware, or as virtually any combination thereof, and that designing the circuitry and/or writing the code for the software and/or firmware would be well within the skill of one of skill in the art in light of this disclosure. In addition, those skilled in the art will appreciate that the mechanisms of the subject matter described herein are capable of being distributed as a program product in a variety of forms, and that an illustrative embodiment of the subject matter described herein applies regardless of the particular type of signal bearing medium used to actually carry out the distribution. Examples of a signal bearing medium include, but are not limited to, the following: a recordable type medium such as a floppy disk, a hard disk drive, a Compact Disc (CD), a Digital Video Disk (DVD), a digital tape, a computer memory, etc.; and a transmission type medium such as a digital and/or an analog communication medium (e.g., a fiber optic cable, a waveguide, a wired communications link, a wireless communication link, etc.).

In a general sense, those skilled in the art will recognize that the various aspects described herein which can be implemented, individually and/or collectively, by a wide range of hardware, software, firmware, or any combination thereof can be viewed as being composed of various types of "electrical circuitry." Consequently, as used herein "electrical circuitry" includes, but is not limited to, electrical circuitry having at least one discrete electrical circuit, electrical circuitry having at least one integrated circuit, electrical circuitry having at least one application-specific integrated circuit, electrical circuitry forming a general purpose computing device configured by a computer program (e.g., a general purpose computer configured by a computer program which at least partially carries out processes and/or devices described herein, or a microprocessor configured by a computer program which at least partially carries out processes and/or devices described herein), electrical circuitry forming a memory device (e.g., forms of random access memory), and/or electrical circuitry forming a communications device (e.g., a modem, communications switch, or optical-electrical equipment). Those having skill in the art will recognize that the subject matter described herein may be implemented in an analog or digital fashion or some combination thereof.

Those having skill in the art will recognize that it is common within the art to describe devices and/or processes in the fashion set forth herein, and thereafter use engineering practices to integrate such described devices and/or processes into data processing systems. That is, at least a portion of the devices and/or processes described herein can be integrated into a data processing system via a reasonable amount of experimentation. Those having skill in the art will recognize that a typical data processing system generally includes one or more of a system unit housing, a video display device, a memory such as volatile and non-volatile memory, processors such as microprocessors and digital signal processors, computational entities such as operating systems, drivers, graphical user interfaces, and applications programs, one or more interaction devices, such as a touch pad or screen, and/or control systems including feedback loops and control motors (e.g., feedback for sensing position and/or velocity; control motors for moving and/or adjusting components and/or quantities). A typical data processing system may be implemented utilizing any suitable commercially available components, such as those typically found in data computing/communication and/or network computing/communication systems.

As used throughout and as would be appreciated by those skilled in the art, "at least one non-transitory computer-readable medium" or "memory 208" may refer to as at least one non-transitory computer-readable medium (e.g., e.g., at least one computer-readable medium implemented as hardware; e.g., at least one non-transitory processor-readable medium, at least one memory (e.g., at least one nonvolatile memory, at least one volatile memory, or a combination thereof; e.g., at least one random-access memory, at least one flash memory, at least one read-only memory (ROM) (e.g., at least one electrically erasable programmable read-only memory (EEPROM)), at least one on-processor memory (e.g., at least one on-processor cache, at least one on-processor buffer, at least one on-processor flash memory, at least one on-processor EEPROM, or a combination thereof), or a combination thereof), at least one storage device (e.g., at least one hard-disk drive, at least one tape drive, at least one solid-state drive, at least one flash drive, at least one readable and/or writable disk of at least one optical drive configured to read from and/or write to the at least one readable and/or writable disk, or a combination thereof), or a combination thereof).

The herein described subject matter sometimes illustrates different components contained within, or connected with, different other components. It is to be understood that such depicted architectures are merely exemplary, and that in fact many other architectures can be implemented which achieve the same functionality. In a conceptual sense, any arrangement of components to achieve the same functionality is effectively "associated" such that the desired functionality is achieved. Hence, any two components herein combined to achieve a particular functionality can be seen as "associated with" each other such that the desired functionality is achieved, irrespective of architectures or intermedial components. Likewise, any two components so associated can also be viewed as being "operably connected", or "operably coupled", to each other to achieve the desired functionality, and any two components capable of being so associated can also be viewed as being "operably couplable", to each other to achieve the desired functionality. Specific examples of operably couplable include but are not limited to physically mateable and/or physically interacting components and/or wirelessly interactable and/or wirelessly interacting components and/or logically interacting and/or logically interactable components.

While particular aspects of the present subject matter described herein have been shown and described, it will be apparent to those skilled in the art that, based upon the teachings herein, changes and modifications may be made without departing from the subject matter described herein and its broader aspects and, therefore, the appended claims are to encompass within their scope all such changes and modifications as are within the true spirit and scope of the subject matter described herein. Furthermore, it is to be understood that the invention is defined by the appended claims.

## Claims

1. A cooling system comprising:
a refrigerant circuit;
an air cooling circuit in fluid communication with the refrigerant circuit, the air cooling circuit including at least one first heat exchanger and at least one fan configured to flow air over the at least one first heat exchanger;
a liquid cooling circuit in fluid communication with the refrigerant circuit, the liquid cooling circuit including at least one second heat exchanger and at least one pump;
a valve assembly configured to selectively flow refrigerant to at least one of the air cooling circuit and the liquid cooling circuit; and
a controller communicatively coupled to the valve assembly and the at least one fan, the controller including one or more processors configured to:
operate the cooling system in a first operating mode in which the air cooling circuit is operative and the liquid cooling circuit is inoperative; and
operate the cooling system in a second operating mode in which the air cooling circuit is inoperative, the liquid cooling circuit is operative, and the at least one fan of the air cooling circuit is selectively operative to cool at least a portion of the cooling system.

2. The cooling system of claim 1, further comprising:
at least one cabinet containing at least a portion of each of the refrigerant circuit, the air cooling circuit, the liquid cooling circuit, and the valve assembly; and
at least one temperature sensor disposed in the at least one cabinet, the at least one temperature sensor configured to sense an internal air temperature in the at least one cabinet;
wherein the controller is communicatively coupled to the at least one temperature sensor, and is further configured to:
when the cooling system is operating in the second operating mode, power on the at least one fan of the air cooling circuit when the internal air temperature in the at least one cabinet exceeds a predefined threshold air temperature.

3. The cooling system of claim 2, wherein the at least one fan of the air cooling circuit is powered on for a predefined time period.

4. The cooling system of claim 3, wherein the controller is further configured to:
when the at least one fan is powered on for the predefined time period, determine from the at least one temperature sensor if the internal air temperature in the at least one cabinet has decreased below the predefined threshold air temperature; and
if the internal air temperature in the at least one cabinet is determined to have decreased to below the predefined threshold air temperature, power off the at least one fan; and
if the internal air temperature in the at least one cabinet is determined not to have decreased below the predefined threshold air temperature, maintain the at least one fan powered on for another consecutive predefined time period.

5. The cooling system of any preceding claim, wherein the at least one first heat exchanger comprises an evaporator coil.

6. The cooling system of any preceding claim, wherein the at least one second heat exchanger comprises a braze plate heat exchanger (BPHE).

7. The cooling system of any of claims 2 to 6, wherein the cabinet does not include a dedicated exhaust fan.

8. A method for controlling a hybrid air/liquid cooling unit, the method comprising:
providing a cabinet defining an interior space, a refrigerant circuit contained in the interior space, an air cooling circuit contained in the interior space and in fluid communication with the refrigerant circuit, the air cooling circuit including at least one first heat exchanger and at least one fan configured to flow air over the at least one first exchanger, a liquid cooling circuit contained in the interior space and in fluid communication with the refrigerant circuit, the liquid cooling circuit including at least one second heat exchanger and at least one pump, and a valve assembly contained in the interior space and configured to selectively flowing refrigerant to at least one of the air cooling circuit and the liquid cooling circuit;
providing a controller communicatively coupled to the valve assembly and the at least one fan, the controller including one or more processors;
operating, by the controller, the hybrid air/liquid cooling unit in a first operating mode in which the air cooling circuit is operative and the liquid cooling circuit is inoperative; and
operating, by the controller, the hybrid air/liquid cooling unit in a second operating mode in which the air cooling circuit is inoperative, the liquid cooling circuit is operative, and the at least one fan is selectively operative to exhaust air from the interior space.

9. The method of claim 8, the method further comprising:
providing at least one temperature sensor disposed in the interior space, the at least one temperature sensor configured to sense an internal air temperature in the interior space, wherein the controller is communicatively coupled to the at least one temperature sensor; and
when the hybrid air/liquid cooling unit is operating in the second operating mode, by the controller, power on the at least one fan when the internal air temperature in the interior space exceeds a predefined threshold air temperature.

10. The method of claim 9, wherein the at least one fan is powered on for a predefined time period.

11. The method of claim 10, the method further comprising:
when the at least one fan is powered on for the predefined time period, by the controller, determine from the at least one temperature sensor if the internal air temperature in the interior space has decreased to below the predefined threshold air temperature; and
if the internal air temperature in the interior space is determined to have decreased to below the predefined threshold air temperature, by the controller, power off the at least one fan; and
if the internal air temperature in the interior space is determined not to have decreased below the predefined threshold air temperature, by the controller, maintain the at least one fan powered on for another consecutive predefined time period.

12. The method of any of claims 8 to 11, wherein the at least one first heat exchanger comprises an evaporator coil, and the at least one second heat exchanger comprises a braze plate heat exchanger (BPHE).

13. The method of any of claims 8 to 11, wherein the cabinet does not include a dedicated exhaust fan.
